# EUROPÄISCHE PATENTANMELDUNG

(11) **EP 1 432 013 A1**
(43) Veröffentlichungstag der Anmeldung: **23.06.2004**
(21) Anmeldenummer: 02102813.9
(22) Anmeldetag: 18.12.2002
(51) Int. Cl.: H01L 21/00, H05K 13/04, H05K 3/10, B05C 11/10

(54) **Halbleiter-Montageeinrichtung zum Auftragen von Klebstoff auf ein Substrat**

(71) Anmelder: Esec Trading S.A., 6330 Cham (CH)
(72) Erfinder: Stalder, Roland, 8050, Zuerich (CH)
(74) Vertreter: Falk, Urs, Dr.

(57) **Zusammenfassung**

Die Erfindung betrifft eine Halbleiter-Montageeinrichtung mit einer Dispensstation zum Auftragen von Klebstoff auf eine bereitgestellte Chip-Montagefläch (3') eines Substrats (2) und mit einer Kamera (11) für die optische Vermessung der Lage der bereitgestellten Chip-Montagefläche (3'). Die optische Achse (12) der Kamera (11) verläuft orthogonal zur bereitgestellten Chip-Montagefläche (3'), damit die Chip-Montagefläche (3') und die Schärfenebene der Kamera (11) bei korrekter Fokussierung der Kamera (11) zusammenfallen. Die Dispensstation weist einen in zwei horizontalen Richtungen bewegbaren Schreibkopf (4) mit einer Schreibdüse (5) mit einer länglichen Form und mit einer einzigen Austrittsöffnung (10) auf. Eine Längsachse (8) der Schreibdüse (5) verläuft unter einem vorbestimmten Winkel (ϕ) schräg zur optischen Achse (12) der Kamera (11), damit der Schreibkopf (4) in dem von der Kamera (11) gelieferten Bild nicht oder höchstens in einem Randbereich sichtbar ist. Sobald die Transportvorrichtung (1) die Chip-Montagefläche (3) zum Auftragen von Klebstoff bereitgestellt hat, kann deren Lage somit verzugslos vermessen werden. Auch die Lage des deponierten Klebstoffs bezüglich der Chip-Montagefläche kann verzugslos gemessen werden, sobald das Auftragen des Klebstoffs beendet ist.

## Beschreibung

Die Erfindung betrifft eine Halbleiter-Montageeinrichtung mit einer Schreibdüse zum Auftragen von Klebstoff auf ein Substrat im Bereich einer Chip-Montagefläche der im Oberbegriff des Anspruchs 1 genannten Art.

Bei der automatisierten Montage von Halbleiterchips auf ein Substrat wird das Substrat von einer Transporteinrichtung taktweise einer Dispensstation, wo Klebstoff aufgetragen wird, und dann einer Bondstation zugeführt, wo der nächste Halbleiterchip plaziert wird. Das Auftragen des Klebstoffs erfolgt entweder mittels einer Dispensdüse, die mehrere Öffnungen aufweist, durch die der Klebstoff ausgeschieden und auf dem Substrat deponiert wird, oder mittels einer Schreibdüse, die eine einzige Öffnung aufweist, durch die der Klebstoff ausgeschieden wird. Die Schreibdüse wird mittels eines in zwei horizontalen Richtungen bewegbaren Antriebssystems entlang einer vorbestimmten Bahn geführt, so dass der deponierte Klebstoff auf dem Substrat ein vorbestimmtes Klebstoffmuster bildet. Eine Dispensdüse mit mehreren Öffnungen ist beispielsweise aus der EP 928 637 bekannt. Eine Halbleiter-Montage Einrichtung mit einer in zwei horizontalen Richtungen bewegbaren Schreibdüse ist aus der EP 901 155 bekannt.

Bei vielen Anwendungen muss der Halbleiterchip mit grosser Genauigkeit auf der Chip-Montagefläche des Substrats platziert werden. Damit die Klebstoffschicht zwischen dem Halbleiterchip und dem Substrat keine Lufteinschlüsse aufweist und den Rand des Halbleiterchips gleichmässig umschliesst (im Fachjargon spricht man von einem schönen Fillet), muss auch der Klebstoff lagegenau auf der Chip-Montagefläche deponiert werden. Bei gewissen Substrattypen, insbesondere bei sogenannten metallischen Leadframes, genügt es, die Lage der Chip-Montagefläche bezüglich der Transportrichtung mittels der am Leadframe vorhandenen Positionierungslöcher zu justieren. Bei anderen Substrattypen, insbesondere bei Substraten, die einen Träger aus Kunststoff aufweisen, ist es hingegen oft erforderlich, die Lage der Chip-Montagefläche nach dem Vorschub des Substrats und vor dem Deponieren des Klebstoffs zu vermessen. Die Vermessung der Chip-Montagefläche erfolgt in der Regel mittels eines Bilderkennungssystems (im Fachjargon Vision genannt). Es sind zwei Varianten bekannt, um die Chip-Montagefläche zu vermessen. Bei der ersten Variante befindet sich die Kamera des Bilderkennungssystems oberhalb der Chip-Montagefläche, so dass die optische Achse der Kamera senkrecht auf die Chip-Montagefläche auftrifft. Um die Chip-Montagefläche zu vermessen, muss die Schreibdüse aus dem Blickfeld der Kamera heraus bewegt und nachher wieder zurück bewegt werden, weil sonst die Schreibdüse den optischen Strahlengang der Kamera abdeckt. Falls zusätzlich zur Vermessung der Chip-Montagefläche vor dem Auftragen des Klebstoffs auch eine Qualitätskontrolle durchgeführt werden soll, die darin besteht, die Lage des deponierten Klebstoffs zu überprüfen, dann muss die Schreibdüse nach dem Auftragen des Klebstoffs nochmals aus dem Blickfeld der Kamera heraus bewegt werden. Diese Bewegungen erfordern Zeit und reduzieren den Durchsatz der Halbleiter-Montageeinrichtung. Bei der zweiten Variante ist die Kamera so angeordnet, dass ihre optische Achse unter einem vorbestimmten Winkel schräg auf die Chip-Montagefläche auftrifft. Nachteilig bei dieser Variante ist, dass die Schärfenebene nicht mit der Chip-Montagefläche zusammenfällt, so dass die Positionierungsmarken auf dem Substrat nicht mit der erforderlichen Genauigkeit vermessen werden können.

Der Erfindung liegt die Aufgabe zugrunde, diese Nachteile zu beheben.

Die genannte Aufgabe wird erfindungsgemäss gelöst durch die Merkmale der Ansprüche 1 und 3.

Die Erfindung betrifft eine Halbleiter-Montageeinrichtung mit einer Dispensstation zum Auftragen von Klebstoff auf eine bereitgestellte Chip-Montagefläche eines Substrats und mit einer Kamera für die optische Vermessung der Lage der bereitgestellten Chip-Montagefläche. Die optische Achse der Kamera verläuft orthogonal zur bereitgestellten Chip-Montagefläche, damit die Chip-Montagefläche und die Schärfenebene der Kamera bei korrekter Fokussierung der Kamera zusammenfallen. Die Dispensstation weist einen in zwei horizontalen Richtungen bewegbaren Schreibkopf mit einer Schreibdüse mit einer länglichen Form und mit einer einzigen Austrittsöffnung auf. Eine Längsachse der Schreibdüse verläuft unter einem vorbestimmten Winkel schräg zur optischen Achse der Kamera, damit der Schreibkopf in dem von der Kamera gelieferten Bild nicht oder höchstens in einem Randbereich sichtbar ist. Als Randbereich ist derjenige Bereich des Bildes anzusehen, der für die Vermessung der Lage der Chip-Montagefläche bedeutungslos ist. Sobald die Transportvorrichtung die Chip-Montagefläche zum Auftragen von Klebstoff bereitgestellt hat, kann deren Lage somit verzugslos vermessen werden. Die Vermessung der Lage der Chip-Montagefläche kann entweder über ihre Konturen erfolgen oder mit Hilfe von der Chip-Montagefläche zugeordneten Positionierungsmarken, sogenannten Fiducials. Sobald das Auftragen des Klebstoffs beendet ist, kann die Lage des deponierten Klebstoffs bezüglich der Chip-Montagefläche ebenfalls verzugslos bestimmt werden.

Nachfolgend wird ein Ausführungsbeispiel der Erfindung anhand der Zeichnung näher erläutert. Die Figuren sind schematisch und nicht massstäblich gezeichnet.

Es zeigen:
- Fig. 1: Teile einer Halbleiter-Montageeinrichtung,
- Fig. 2: ein Substrat mit mehreren Chip-Montageflächen, und
- Fig. 3: eine Schreibdüse.

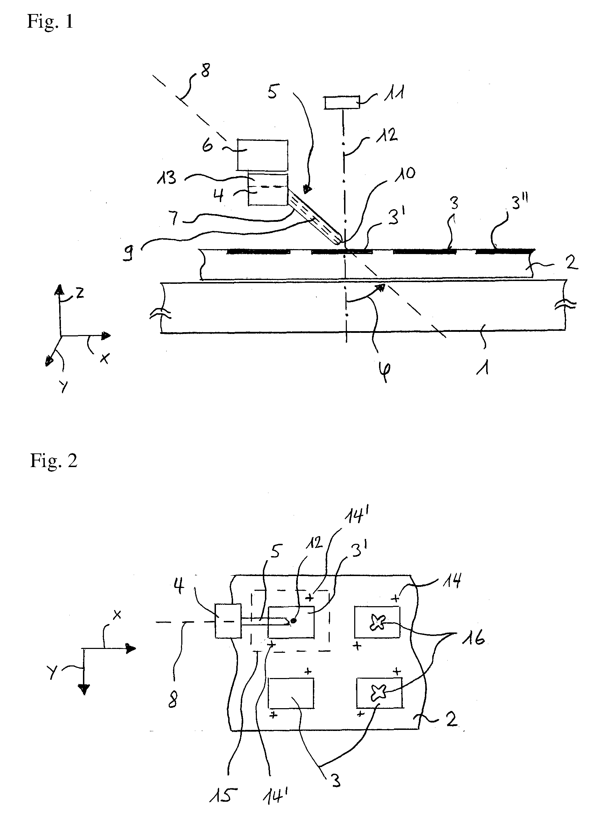

Die Fig. 1 zeigt in seitlicher Ansicht die für das Verständnis der Erfindung nötigen Teile einer Halbleiter-Montageeinrichtung. Mit x, y und z sind die Achsen eines kartesischen Koordinatensystems bezeichnet, wobei die beiden Achsen x und y in einer horizontalen Ebene verlaufen. Die x-Achse bezeichnet zudem die Transportrichtung einer Transportvorrichtung 1 für den Transport eines Substrates 2. Das Substrat 2 weist eine vorbestimmte Anzahl von Chip-Montageflächen 3, 3' auf, die in regelmässigen Abständen angeordnet sind. Die Transportvorrichtung 1 ermöglicht zudem eine Verschiebung des Substrats 2 entlang der y-Achse. Die Transportvorrichtung 1 transportiert das Substrat 2 in der Transportrichtung x zunächst zu einer Dispensstation, wo Klebstoff auf die bereitgestellte Chip-Montagefläche 3' aufgetragen wird, und dann zu einer Bondstation, wo ein Halbleiterchip auf der Chip-Montagefläche 3" platziert wird. Eine solche Transportvorrichtung 1 ist beispielsweise aus der EP 330 831 bekannt. Die Dispensstation umfasst einen Schreibkopf 4 mit einer Schreibdüse 5. Ein Antriebssystem 6 ermöglicht die Bewegung des Schreibkopfs 4 in den drei Richtungen x, y und z. Ein geeignetes Antriebssystem 6 ist beispielsweise aus der EP 901 155 bekannt. Die Schreibdüse 5 ist vorzugsweise auswechselbar am Schreibkopf 4 befestigt. Die Schreibdüse 5 weist eine längliche Form auf: Sie besteht aus einem länglichen Körper 7 mit einer entlang der Längsachse 8 des Körpers 7 verlaufenden Bohrung 9, die in eine einzige Austrittsöffnung 10 mündet. Die Halbleiter-Montageeinrichtung umfasst weiter eine Kamera 11 für die Vermessung der zum Auftragen von Klebstoff bereitgestellten Chip-Montagefläche 3'. Die optische Achse 12 der Kamera 11 verläuft parallel zur z-Achse. Die optische Achse 12 der Kamera 11 verläuft somit senkrecht zur Chip-Montagefläche 3'. Bei korrekter Fokussierung der Kamera 11 liegt die ganze Chip-Montagefläche 3' in der Schärfenebene der Kamera 11. Erfindungsgemäss ist die Schreibdüse 5 so am Schreibkopf 4 angeordnet, dass ihre Längsachse 8 mit der z-Achse bzw. der optischen Achse 12 der Kamera 11 einen vorbestimmten Winkel ϕ einschliesst. Der Winkel ϕ liegt typischerweise im Bereich von 30° bis 60°. Somit befindet sich nur die Spitze der Schreibdüse 5 im Bereich der optischen Achse 12 der Kamera 11. Ein Teil der Schreibdüse 5 befindet sich nach wie vor im Blickfeld der Kamera 11. Die Länge der Schreibdüse 5 ist so bemessen, dass sich der Schreibkopf 4 ausserhalb des Blickfeldes der Kamera 11 befindet oder höchstens einen Randbereich des Blickfeldes der Kamera 11 bzw. des von der Kamera 11 gelieferten Bildes abdeckt. Die Schreibdüse 5 ist über eine Pumpe 13 mit einem Klebstoffreservoir verbunden. Die Pumpe 13 kann wie im gezeigten Beispiel im Schreibkopf 5 integriert sein oder stationär auf der Halbleiter-Montageeinrichtung angeordnet sein. Die Pumpe 13 steuert das Ausscheiden des Klebstoffs aus der Schreibdüse 5.

Die Fig. 2 zeigt in Aufsicht das Substrat 2 mit den Chip-Montageflächen 3, von denen eine Chip-Montagefläche 3' nach dem Transport durch die Transportvorrichtung 1 bereitgestellt ist zum Auftragen von Klebstoff. Bei diesem Beispiel weist das Substrat 2 in zwei Reihen angeordnete Chip-Montageflächen 3 auf. Die optische Achse 12 der Kamera 11 (Fig. 1) durchstösst die bereitgestellte Chip-Montagefläche 3' in der Nähe ihres Zentrums. Das Substrat 2 ist mit Positionierungsmarken 14, im Fachjargon "Fiducial" genannt, versehen, die neben den Chip-Montageflächen 3 angeordnet sind. Im Beispiel dienen Kreuze als Positionierungsmarken 14. Die zur bereitgestellten Chip-Montagefläche 3' gehörenden Positionierungsmarken 14' befinden sich innerhalb des durch eine gestrichelte Linie berandeten Blickfeldes 15 der Kamera 11. Das von der Kamera 11 gelieferte Bild entspricht dem im Blickfeld 15 liegenden Bereich des Substrats 2. Die Spitze der Schreibdüse 5 und mindestens ein Teil des länglichen Körpers 7 der Schreibdüse 5 befinden sich innerhalb des Blickfeldes 15 der Kamera 11. Weil die Längsachse 8 der Schreibdüse 5 schräg zur optischen Achse 12 der Kamera 11 verläuft, ist in dem von der Kamera 11 gelieferten Bild aufgrund der begrenzten Schärfentiefe nur die Spitze der Schreibdüse 5 optisch scharf dargestellt, während der restliche Teil ihres Körpers 7 zunehmend unschärfer wird. Der wesentliche Vorteil der Erfindung liegt aber darin, dass die Positionierungsmarken 14' permanent sichtbar sind, d.h. sowohl vor dem Auftragen, während des Auftragens, als auch nach dem Auftragen des Klebstoffs auf die Chip-Montagefläche 3', weil sich der Schreibkopf 4 im Prinzip entweder vollständig ausserhalb des Blickfeldes 15 der Kamera 11 oder höchstens in einem Randbereich innerhalb des Blickfeldes 15 der Kamera 11 befindet. Der Schreibkopf 4 deckt also die Positionierungsmarken 14' nicht mehr ab, wie dies im Stand der Technik der Fall ist, wenn die optische Achse 12 der Kamera 11 senkrecht zur Chip-Montagefläche 3' verläuft. Es ist zwar bei gewissen Anwendungen unter Umständen möglich, dass der Schreibkopf 4 mindestens eine der Positionierungsmarken 14' während des Auftragens von Klebstoff vorübergehend kurzzeitig abdeckt. Dies stellt aber keinen Nachteil dar, da sowohl die Vermessung der Chip-Montagefläche 3' vor dem Auftragen des Klebstoffs als auch die Bestimmung der Lage des deponierten Klebstoffs bezüglich der Chip-Montagefläche 3' nach dem Auftragen des Klebstoffs problemlos durchgeführt werden kann. Der auf den bereits prozessierten Chip-Montageflächen 3 deponierte Klebstoff ist mit dem Bezugszeichen 16 bezeichnet.

Bei der Abarbeitung von Substraten, bei denen die Lage der Chip-Montagefläche nach dem Bereitstellen zum Auftragen von Klebstoff bestimmt werden muss, arbeitet die Halbleiter-Montage Einrichtung im Betrieb wie folgt:
a) Das Substrat wird von der Transportvorrichtung 1 in Transportrichtung x und/oder in y-Richtung vorgeschoben und eine nächste Chip-Montagefläche 3' bereitgestellt zum Auftragen von Klebstoff.
b) Die Lage der Chip-Montagefläche 3' bzw. der zur bereitgestellten Chip-Montagefläche 3' gehörenden Positionierungsmarken 14' wird mittels der Kamera 11 vermessen und eine allfällige Abweichung der Ist-Lage zur Soll-Lage der Chip-Montagefläche 3' berechnet und für die Positionierung der Schreibdüse 5 im nächsten Schritt verwendet.
c) Die Schreibdüse 5 wird bezüglich der x-und der y-Richtung lagegenau am Anfang der zu schreibenden Klebstoffbahn positioniert und auf die erforderliche z-Höhe abgesenkt.
d) Die Schreibdüse 5 wird in der xy-Ebene entlang einer vorbestimmten Bahn geführt, wobei sie Klebstoff ausscheidet, so dass auf der Chip-Montagefläche 3' eine Klebstoffspur zurückbleibt, die das gewünschte Klebstoffmuster bildet.
e) Nach der Beendigung des Schreibvorganges wird die Schreibdüse 5 in z-Richtung angehoben. Gleichzeitig kann, allerdings fakultativ, die Lage des deponierten Klebstoffs bezüglich der Chip-Montagefläche 3' mittels der Kamera 11 vermessen werden.
f) Der Schreibzyklus ist nun beendet. Wenn auch der Bondzyklus beendet ist, kann das Substrat 2 weiter transportiert werden, um eine nächste Chip-Montagefläche bereitzustellen.

Es gibt aber auch Substrate (beispielsweise die eingangs erwähnten Leadframes), bei denen die Lage der Chip-Montagefläche vor dem Auftragen des Klebstoffs nicht bestimmt werden muss, da die Positionierung mit ausreichender Genauigkeit durch die Transportvorrichtung 1 (Fig. 1) erfolgt, bei denen aber im Schritt e die Lage des deponierten Klebstoffs 16 bezüglich der Chip-Montagefläche 3' im Sinne einer Qualitätskontrolle bestimmt werden muss. Dank der Erfindung kann auch diese Messung verzugslos erfolgen, sobald das Auftragen des Klebstoffs beendet ist.

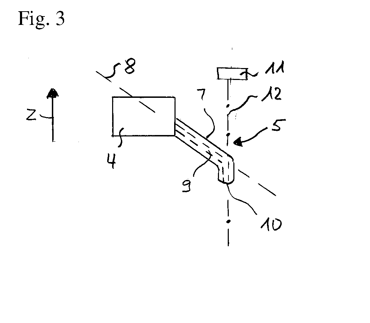

Die Fig. 3 zeigt in seitlicher Ansicht den Schreibkopf 4 mit einer Schreibdüse 5, deren Spitze gegenüber der Längsachse 8 abgewinkelt ist, so dass das letzte, an die Austrittöffnung 10 angrenzende Stück der Bohrung 9 parallel zur z-Achse bzw. parallel zur optischen Achse 12 der Kamera 11 verläuft.

Die Halbleiter-Montageeinrichtung umfasst auch eine Bondstation mit einem Bondkopf und einem gegenüber dem Bondkopf in vertikaler Richtung auslenkbaren Chipgreifer. Der Bondkopf transportiert jeweils einen Halbleiterchip von einem Wafertisch zur bereitgestellten Chip-Montagefläche. Auch hier besteht das Problem, dass sich der Bondkopf beim Aufnehmen des Halbleiterchips vom Wafertisch und/oder beim Plazieren des Halbleiterchips auf der Chip-Montagefläche vorübergehend im Strahlengang einer entsprechenden Kamera befindet. Die vorliegende Erfindung verschafft auch hier Abhilfe, wenn der Chipgreifer analog zur Schreibdüse ausgebildet wird, nämlich mit einem schräg zur vertikalen Achse z verlaufenden Körper mit dem Resultat, dass sich die Spitze des Chipgreifers seitlich neben dem Bondkopf befindet, so dass sich der Bondkopf ausserhalb des Blickfeldes der Kamera befindet.

## Patentansprüche

1. Halbleiter-Montageeinrichtung, mit einer Dispensstation zum Auftragen von Klebstoff auf eine bereitgestellte Chip-Montagefläche (3') eines Substrats (2) und mit einer Kamera (11) für die optische Vermessung der Lage der bereitgestellten Chip-Montagefläche (3'), wobei eine optische Achse (12) der Kamera (11) orthogonal zur bereitgestellten Chip-Montagefläche (3') verläuft, wobei die Dispensstation einen in zwei horizontalen Richtungen bewegbaren Schreibkopf (4) mit einer Schreibdüse (5) mit einer länglichen Form und mit einer einzigen Austrittsöffnung (10) aufweist, **dadurch gekennzeichnet, dass** eine Längsachse (8) der Schreibdüse (5) unter einem vorbestimmten Winkel (ϕ) schräg zur optischen Achse (12) der Kamera (11) verläuft, und dass die Länge der Schreibdüse (5) so bemessen ist, dass der Schreibkopf (4) unmittelbar nach dem Bereitstellen der Chip-Montagefläche (3') zum Auftragen von Klebstoff in dem von der Kamera (11) gelieferten Bild nicht oder höchstens in einem Randbereich sichtbar ist, damit die Vermessung der Chip-Montagefläche (3') nach dem Bereitstellen verzugslos durchgeführt werden kann.

2. Halbleiter-Montageeinrichtung nach Anspruch 1 für die Bearbeitung von Substraten (2), bei denen jeder Chip-Montagefläche (3, 3') Positionierungsmarken (14, 14') zugeordnet sind, **dadurch gekennzeichnet, dass** der Schreibkopf (4) die zur bereitgestellten Chip-Montagefläche (3') gehörenden Positionierungsmarken (14) unmittelbar nach dem Bereitstellen der Chip-Montagefläche (3') zum Auftragen von Klebstoff in dem von der Kamera (11) gelieferten Bild nicht abdeckt.

3. Halbleiter-Montageeinrichtung, mit einer Dispensstation zum Auftragen von Klebstoff auf eine bereitgestellte Chip-Montagefläche (3') eines Substrats (2) und mit einer Kamera (11) für die optische Vermessung der Lage des deponierten Klebstoffs bezüglich der Chip-Montagefläche (3'), wobei eine optische Achse (12) der Kamera (11) orthogonal zur bereitgestellten Chip-Montagefläche (3') verläuft, wobei die Dispensstation einen in zwei horizontalen Richtungen bewegbaren Schreibkopf (4) mit einer Schreibdüse (5) mit einer länglichen Form und mit einer einzigen Austrittsöffnung (10) aufweist, **dadurch gekennzeichnet, dass** eine Längsachse (8) der Schreibdüse (5) unter einem vorbestimmten Winkel (ϕ) schräg zur optischen Achse (12) der Kamera (11) verläuft, und dass die Länge der Schreibdüse (5) so bemessen ist, dass der Schreibkopf (4) nach dem Auftragen von Klebstoff in dem von der Kamera (11) gelieferten Bild nicht oder höchstens in einem Randbereich sichtbar ist, damit die Lage des deponierten Klebstoffs bezüglich der Chip-Montagefläche (3') verzugslos bestimmt werden kann.
